# EUROPEAN PATENT APPLICATION

(11) **EP 4 246 542 A1**
(43) Date of publication of application: **20.09.2023**
(21) Application number: 22162776.3
(22) Date of filing: 17.03.2022
(51) Int. Cl.: H01F 17/00, H01F 27/29, H01F 41/04, H01L 49/02, H01F 17/04

(54) **AN INDUCTOR INLAY FOR A COMPONENT CARRIER, AND MANUFACTURING METHOD**

(71) Applicant: AT & S Austria Technologie & Systemtechnik Aktiengesellschaft, 8700 Leoben-Hinterberg (AT)
(72) Inventor: Weis, Gerald, 8600 Bruck an der Mur (AT); Kastelic, Markus, 8740 Zeltweg (AT); Weidinger, Gerald, 8700 Leoben (AT); Alothman Alterkawi, Ahmad Bader, 8020 Graz (AT); Stahr, Johannes, 8605 St. Lorenzen im Mürztal (AT)
(74) Representative: Dilg, Haeusler, Schindelmann Patentanwaltsgesellschaft mbH

(57) **Abstract**

It is described an inductor inlay (150), comprising:
i) a magnetic layer stack (160), comprising a plurality of interconnected magnetic layers (161, 162); and
ii) an electrically conductive structure (120) embedded in the magnetic layer stack (160), wherein the electrically conductive structure (120) is configured as an inductor element (120) that comprises a coil-like shape.

Further, a component carrier and a manufacturing method are described.

## Description

### Field of the Invention

The invention relates to an inductor inlay with a magnetic layer stack, comprising a plurality of interconnected magnetic layers, and
an electrically conductive structure embedded in the magnetic layer stack. The invention further relates to a component carrier that comprises the inductor inlay. Further, the invention relates to a method of manufacturing the inductor inlay.

Accordingly, the invention may relate to the technical field of magnetic/inductive applications in component carriers such as printed circuit boards or IC substrates.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically and magnetically reliable so as to be operable even under harsh conditions.

Moreover, an extended functionality of component carriers is demanded by users. For example, it is known to integrate magnetic material in a component carrier in order to provide/enhance an inductance for specific applications. However, conventional approaches may suffer from low inductance values and high production costs.

### Summary of the Invention

There may be a need to provide/manufacture an increased magnetically enhanced inductance for a component carrier in a (cost-) efficient manner.

An inductor inlay, a component carrier, and a method of manufacturing are provided.

According to an aspect of the invention an inductor inlay (in particular for a component carrier) is provided, the inlay comprising:
i) a magnetic layer stack, comprising a plurality (in particular two, three, or more) of interconnected magnetic layers (in particular comprising a magnetic matrix); and
ii) an electrically conductive structure embedded in the magnetic layer stack, wherein the electrically conductive structure is configured as an inductor element that comprises a coil-like shape.

According to a further aspect of the invention, there is described a method of manufacturing an inductor inlay, wherein the method comprises:
stacking a plurality of magnetic layers to provide a magnetic layer stack, thereby:
interconnecting the plurality of magnetic layers; and
embedding an electrically conductive structure in the magnetic layer stack, wherein the electrically conductive structure is configured as an inductor element that comprises a coil-like shape.

According to a further aspect of the invention, there is described a component carrier, wherein the component carrier comprises:
i) a stack comprising at least one electrically conductive layer structure and at least one electrically insulating layer structure; and
ii) an inductor inlay as described above, wherein the inductor inlay is assembled to the stack (in particular embedded in or surface-mounted to the stack).

In the context of the present document, the term "magnetic layer" may in particular refer to a layer structure (i.e. a continuous or discontinuous layer) that comprises a magnetic material, also termed magnetic matrix. The term "magnetic matrix" may in particular refer to a base material (base substance) that comprises magnetic properties. The base material may be magnetic itself or magnetic particles may be distributed within a non-magnetic matrix material. The magnetic matrix may be configured for example rigid/solid (e.g. as magnetic sheets), viscous (magnetic paste), or magnetic resin (viscous/liquid). The magnetic matrix may comprise electrically conductive material/particles and/or electrically insulating material/particles. Further, the magnetic matrix may be configured to have a relative magnetic permeability µᵣ in a range from 2 to 10⁶, in particular 20 to 80. A plurality of different materials may be considered suitable to provide the base material and/or the embedded particles of the magnetic matrix, for example a ferromagnetic material (like iron), a ferrimagnetic material (like ferrite), a permanent magnetic material, a soft magnetic material, a metal oxide. In an example, the magnetic particles may also be electrically conductive. To prevent a short circuit in this case, the magnetic particles are preferably electrically insulated to the metal (copper) traces of the inductor inlay and/or other electrically conductive material in direct contact to the magnetic material. For example, the magnetic particles may be at least partially covered with an electrically insulating material (e.g. a coating) and/or the portions (e.g. the entire surface area) of metal traces, which are in direct contact with the magnetic material, are covered with a further electrically insulating material, e.g. coating and/or ink.

In an example, a dielectric (resin) matrix with magnetic particles therein is used. In another example, magnetic sheets are applied that comprise magnetic particles embedded in a fiber-enforced resin formulation (e.g. prepreg). In a further example, a magnetic paste is used that comprises magnetic particles embedded in a not fiber-enforced resin formulation. A (non-fiber enforced) resin may comprise additives, e.g. hardeners. In a further example, the magnetic matrix is arranged in the inlay in a planar manner.

In the context of the present document, the term "inlay" may refer to a separate component/element that is manufactured in an inlay manufacturing process being (essentially) independent from the component carrier manufacturing process. The inlay may be configured to be surface mounted on or embedded in said component carrier. However, the inlay may be produced, sold, and shipped completely independent of the component carrier. Nevertheless, in an embodiment, the manufacturing process of inductor inlay and component carrier may be intertwined. The inlay may also be termed "inductor component" and may particularly denote a standalone electronic member which provides an inductance in the framework of an electronic application in which the inductor component is implemented. The inlay may be formed on the basis of component carrier technology, in particular on the basis of printed circuit board (PCB) technology, and may be surface-mounted or embedded in a separately formed component carrier such as a PCB. However, the inlay component may also be used in conjunction with non-component carrier applications.

The inductor inlay may be essentially shaped as a plate, meaning that it comprises two directions of main extension along the x- and y-axes and a comparably short extension along the z-axis. In this context, the term "horizontal" may thus mean "oriented in parallel with a direction of main extension", while the term "vertical" may mean "oriented perpendicular to the directions of main extension". Hence, even if the inlay is turned around, the terms "vertical" and "horizontal" always have the same meaning. Further, the inductor inlay may comprise different shapes, for example one of circular, rectangular, polygonal.

In a preferred embodiment, the inductor inlay comprises the magnetic matrix in magnetic layers and the electrically conductive structure (a conductor track, e.g. a copper trace) that is (at least partially) (in particular fully) embedded in the magnetic matrix to provide the inductive element. Thereby, a planar inductive element may be provided in an efficient, robust, and cost-saving manner. The magnetic matrix may encapsulate (fully) the electrically conductive structure in the stack and thus significantly increase the inductance value. Using a inductor inlay assembled to a component carrier, a large amount of magnetic material may be applied, which may lead in turn to the high inductance value.

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, a metal core substrate, an inorganic substrate and an IC (integrated circuit) substrate. A component carrier may also be a hybrid board combining different ones of the above mentioned types of component carriers.

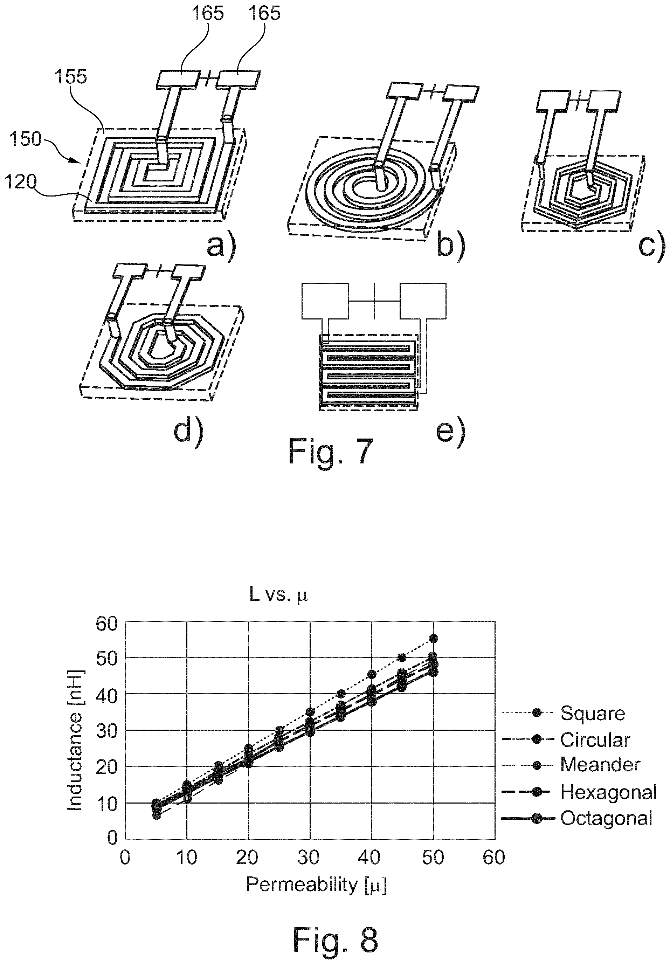

According to an exemplary embodiment, the invention may be based on the idea that an increased magnetically enhanced inductance for a component carrier can be provided and manufactured in a (cost-)efficient manner, when an inductor element is sandwiched in between at least two magnetic layers within a magnetic layer stack. Such a magnetic layer stack may be used as a flexible inductor inlay that can be assembled to a component carrier in a large variety of design options. The inlay may be manufactured independent of the component carrier with a high amount of magnetic material and provide hence a high inductance value. Depending on different parameters such as shape and number of windings of the inductor coil, thickness ratio of inductor element and magnetic material, or line/shape ratio (see Figures 7 to 12), the inductance value of the inductor inlay may be adjusted (tuned) depending on the desired circumstances.

Further, such an inlay may be manufactured in an especially efficient manner by forming the magnetic layer stack and, at the same time, embedding the inductor element. For example, the inductor element may be formed (preferably with terminal connections) in a dielectric layer, which is then removed, so that the inductor element can be arranged on a first magnetic layer. In a further step, a second magnetic layer may be arranged on top of the first magnetic layer, thereby encapsulating the inductor element with magnetic material and forming the magnetic layer stack.

### Description of Exemplary Embodiments

According to an embodiment, the magnetic layer stack comprises exactly two magnetic layers or exactly three magnetic layers. Thereby, a thin (in the z-direction) but robust and secure embedding of the inductor element may be enabled. In an embodiment, the magnetic material, that is arranged between the windings of the coil, may be considered as a third magnetic layer. The third magnetic layer may be produced by magnetic material of the first or second magnetic layer that flows and/or is pressed into the hollow spaces between the windings. The magnetic layers may be provided as magnetic sheets that are laminated on a substrate such as a temporary carrier and/or onto each other.

At an interface between the first magnetic layer and the second magnetic layer, there may be a shift pattern that reflects a manufacturing step of laminating the layers together. The shift pattern may be observable visually or using a microscope.

In a further example, the inlay comprises exactly four, exactly five, or exactly six magnetic layers. In a further example, the inlay comprises more than six layers.

According to a further embodiment, the shift pattern comprises at least one of the group which consists of an alignment shift, a smearing, a tapering. Thus, in the finished inlay or component carrier product, the manufacturing process of providing at least two different magnetic layers is directly reflected.

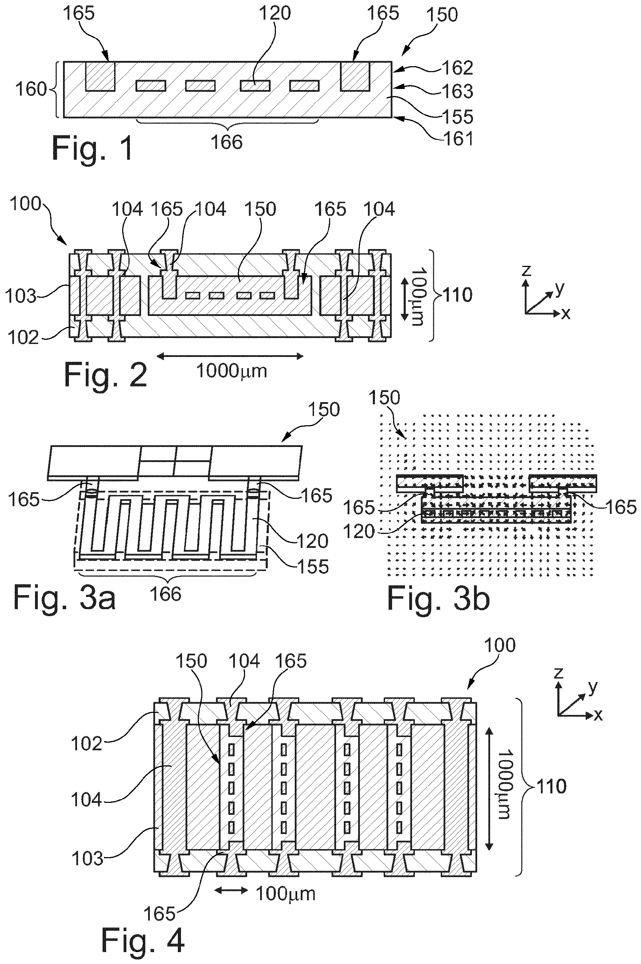

According to a further embodiment, the magnetic matrix continuously fills a volume around the electrically conductive structure (and between windings of the electrically conductive structure (see e.g. Figure 3)). This may provide the advantage that the electrically conductive structure is enclosed in a stable and robust manner. Further, this may provide the advantage that a high amount of magnetic material can be applied, and an accordingly high inductance can be achieved. The described (planar) inductor inlay/matrix may allow for applying a high amount of magnetic matrix (that fills all the space between the vias). In this manner, functionally unused area/volume inside the component carrier may be replaced by portions that interact with magnetic fields (thereby functionalizing the unused area/volume).

According to a further embodiment, the inductor element is embedded horizontally (extends in parallel with respect to the stacked layers) in the magnetic layer stack. According to a further embodiment, the electrically conductive structure is arranged in the center of the inductor inlay (in particular with respect to the vertical direction z). In other words, the electrically conductive structure is arranged in the middle of the inductor inlay/matrix in the horizontal direction (along x- and y-axes). In this manner, a specifically efficient inductance value and stability may be provided.

According to a further embodiment, the inductor element is embedded vertically (extends perpendicular with respect to the stacked layers) in the magnetic layer stack. In other words, the electrically conductive structure is arranged in the middle of the inductor inlay/matrix in the vertical direction (along z-axis). In this manner, interesting design options and stability may be provided.

According to a further embodiment, at least one of the magnetic layers is partially or entirely dielectric. This may provide the advantage that the magnetic layer/stack is not interfering with electrically conductive layer structures of a component carrier and/or the inductor element.

According to a further embodiment, the magnetic matrix comprises at least one of the group consisting of a rigid solid, and a paste. Depending on the desired functionality, different configurations of the magnetic matrix may be especially suitable. For example, the magnetic matrix may be configured as a magnetic sheet (rigid) that can be laminated. In this example, the magnetic matrix may comprise a prepreg or another resin (e.g. sheet) with embedded magnetic particles. In another example, the magnetic matrix may be configured as a magnetic paste (viscous) that could be filled/poured in a mold to manufacture the magnetic element.

According to a further embodiment, the magnetic matrix comprises one of the group which consists of: electrically conductive, electrically insulating, partially electrically conductive and partially electrically insulating (e.g. a first electrically conductive part and a second electrically insulating part). Depending on the desired functionality, different configurations of the magnetic matrix may be especially suitable.

According to a further embodiment, the relative magnetic permeability µᵣ of the magnetic matrix is in a range from 1.1 to 500, in particular 2 to 150, more in particular 4 to 80. These values are comparably high and can lead to an advantageously high inductance value. Permeability is the measure of magnetization that a material obtains in response to an applied magnetic field. The relative permeability, denoted by the symbol µᵣ, is the ratio of the permeability of a specific medium µ to the permeability of free space µ₀ (vacuum).

According to a further embodiment, the magnetic matrix comprises at least one material of the group consisting of a ferromagnetic material (e.g. iron, nickel), a ferrimagnetic material, a permanent magnetic material, a soft magnetic material, a ferrite, a metal oxide (e.g. magnetite), a dielectric matrix (e.g. a resin), in particular a prepreg (or resin sheet), with magnetic particles therein, and an alloy, in particular an iron alloy or alloyed silicon, more in particular wherein the metallic particles comprise at least one of the group consisting of ferrite, a 3d material, and a 4f material. Thereby, established materials can be directly applied to manufacture the magnetic matrix in a cost-efficient manner.

In an example, in case of conductive magnetic material particles, the conductive material (copper) should be isolated against the magnetic material particles to avoid shortcuts (e.g. resin, phenolic, parylene).

A permanent magnetic material may be ferromagnetic material or ferrimagnetic material, and may for instance be provided on the basis of transition metals (with partially filled 3d shell) such as iron or nickel, or on the basis of rare earths (with partially filled 4f shell).

A soft magnetic material may be a material which can be easily remagnetized, i.e. having a small area of its hysteresis curve. In other words, soft magnetic materials are those materials that are easily magnetized and demagnetized. They may have intrinsic coercivity less than 1000 Am⁻¹.

A ferrite may be denoted as a type of ceramic compound composed of Fe₂O₃ combined chemically with one or more additional metallic elements. Ferrites are both electrically non-conductive and ferrimagnetic, so they can be magnetized or attracted by a magnet. Ferrites may be implemented as hard ferrites or soft ferrites, depending on the application.

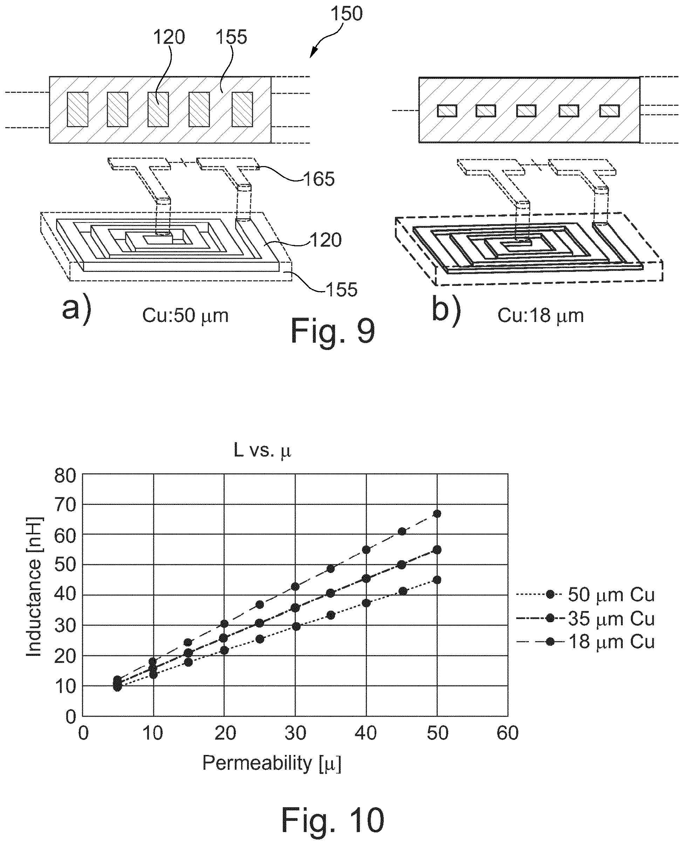

According to a further embodiment, a thickness of the magnetic material (matrix) in the stack (in comparison to the material of the inductor element) is in the range from 2% to 98%, in particular 5% to 95%, more in particular 10% to 90% of the total thickness of the total magnetic layer stack thickness. In other words, the magnetic layers are significantly thicker than the inductor element in the vertical direction. This may provide the advantage that the inductance value can be increased (see Figures 9 and 10). For example, this holds true for a cross-section (along the z-direction) through the first magnetic layer, the inductor element, and the second magnetic layer. In another cross-section through the first magnetic layer and the second magnetic layer only, the thickness would comprise 100% magnetic material.

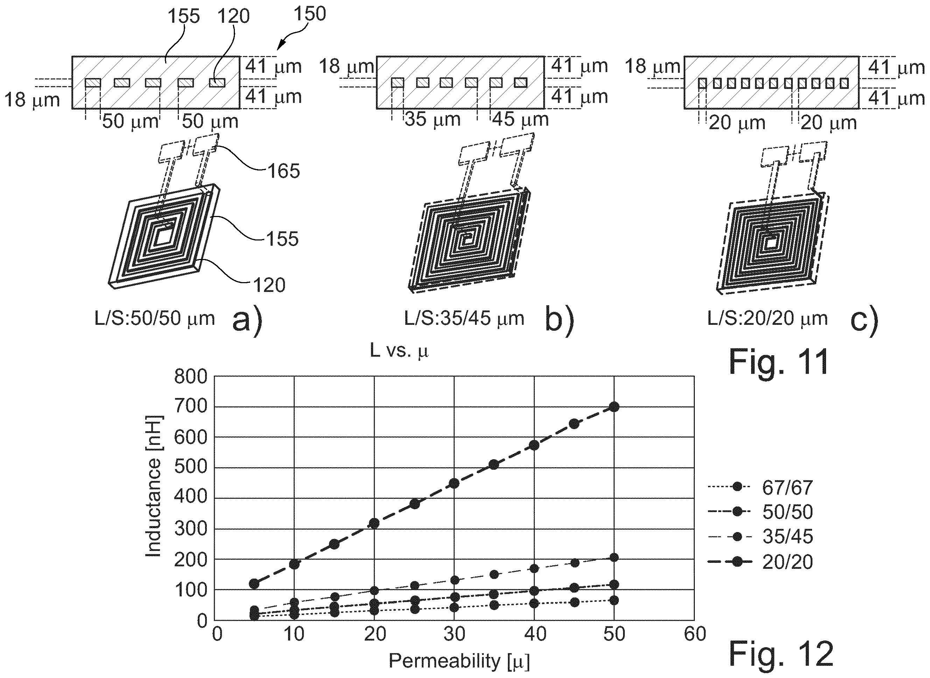

According to a further embodiment, in a horizontal direction (along x/y-direction, parallel to stacked layers) a ratio between the width of the inductor element conductor track and the width of the magnetic material (of the magnetic layers) (line/space ratio) is in the range 0.5 to 1.5, in particular 0.75 to 1.25, more in particular around 1. In an example, the widths are 500 µm or smaller, in particular 100 µm or smaller, in particular 50 µm or smaller, more in particular 25 µm or smaller. This may provide the advantage that the inductance value can be increased (see Figures 11 and 12).

According to a further embodiment, the inductance value (in nH) of the inductor inlay is 5 or larger, in particular 10 or larger, more in particular 25 or larger, more in particular 50 or larger, more in particular 100 or larger, more in particular 250 or larger, more in particular 500 or larger. Depending on the parameters discussed above (shape of coil, thickness of coil and magnetic layers, line-space ratio, magnetic permeability), the inductance value may be adjusted to a desired range. Specifically, a surprisingly high inductance value may be achieved based on the described inductance tuning.

According to a further embodiment, the inductor element is meander-shaped and/or spiral-shaped. In other words, the inductor element comprises a conductor track configured to overlap its own portions along its transversal direction at least two times in order to alternate the space among two portions of said track and the track portions. In an example, the conductor track extents along a spiral shape. Said shape can have e.g. a circular, or square, or hexagonal, octagonal shape. Further, the conductor track can extend along a meander shape.

In the context of the present document, the term "winding" may particularly denote a loop structure (which may be similar to a helical structure with corners), wherein multiple of such loops may form a coil-type (coil-like) arrangement. The term "coil-like" may also include meander-like shapes. Due to the component carrier manufacturing technology (for instance involving lamination) of the inductor inlay and/or due to the used component carrier raw materials (for instance involving planar constituents such as plates and foils), the windings of the coil (like) structure may have edge-like or corner-like portions rather than being limited to a composition of multiple interconnected purely circular structures.

According to a further embodiment, the directions of main extension (length x and width y) of the windings are (essentially) parallel to the directions of main direction (length x and width y) of the inductor inlay (and/or the component carrier, when the inductor inlay has been assembled).

According to a further embodiment, the electrically conductive structure (conductor track of the inductor element) comprises a number of windings in the range between two and one hundred, in particular between three and eight. In a specific example, it has been surprisingly turned out that a number of windings in this range may resemble an efficient compromise between large inductance value and manufacture costs.

According to a further embodiment, the windings of the electrically conductive structure comprise one of a rectangular shape, a round shape, a polygonal shape, a spiral shape (in particular a spiral that is rectangular/squared or circular). Hence, the design flexibility, when determining the shape of the electrically conductive structure, may be considered advantageously high. In a specific example, a rectangular shape (see e.g. Figure 3), together with a number of turns in the range two to one hundred, in particular three to eight, may yield an especially advantageous inductance value.

According to a further embodiment, the inductor element comprises at least two terminal sections exposed with respect to the magnetic layers, in particular with respect to the magnetic layer stack. One terminal may be connected to an internal section of the inductor element, while another terminal is connected to an external section of the inductor element. In an example, in case of a spiral shape, at least the internal terminal section vertically extends through the magnetic layer(s) and is exposed at a layer stack (main) surface.

According to a further embodiment, the magnetic layer stack comprises a further electrically conductive structure (further inductor element) embedded in a magnetic layer of the stack, in particular above the electrically conductive structure in a vertical (z) direction. The further inductor element may comprise a third and a fourth terminal section. At least one of the two terminal sections of the inductor element may be (electrically) connected to one of the third and fourth terminal sections of the further second inductor (assembled in series). The interconnection may be arranged in the same horizontal layer (x, y)and/or in the stack thickness direction (z). This embodiment may provide the advantage that a desirable inductive behaviour may be achieved with low manufacture effort.

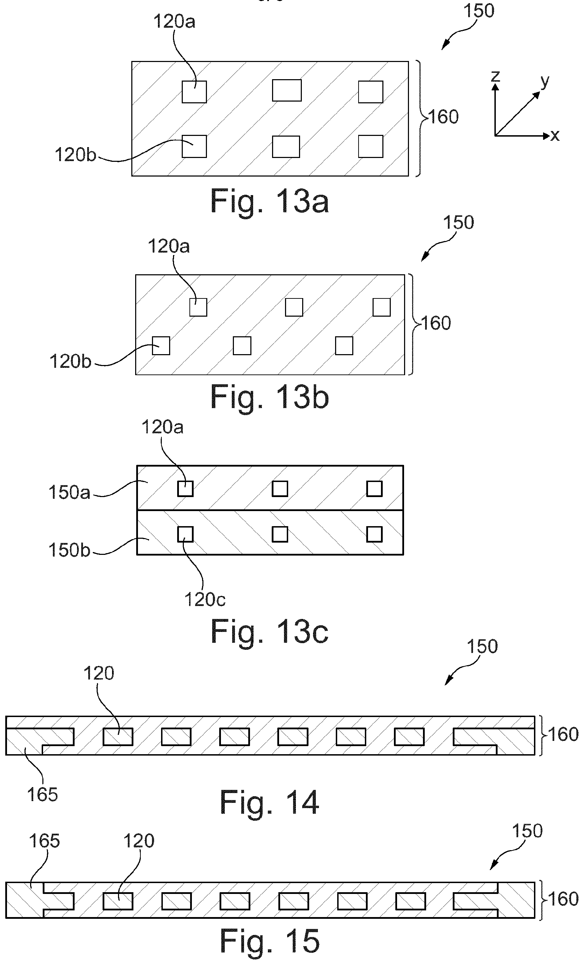

According to a further embodiment, the inductor element and the further inductor element are (essentially) stacked on top of each other in the vertical direction (z). The inductor elements may hereby be aligned (see Figure 13a). In another example, the inductor element and the further inductor element are displaced with respect to each other in the vertical direction (see Figure 13b). Thereby, physical phenomena such as constructive/destructive interference could be advantageously used. For example, constructive interferences may efficiently tune the inductance.

According to a further embodiment, the inductor inlay comprises a plurality of magnetic layers and a plurality of inductor elements embedded in respective magnetic layers. While in one example, all inductor elements are vertically aligned, in another example, none of the inductor elements are vertically aligned. In further examples, only some of the inductor elements are vertically aligned.

According to a further embodiment, there is provided an arrangement of inductor inlays that comprises at least two of the described inductor inlays stacked on top of each other. In this manner, the above described architecture with two or more inductor elements stacked in the vertical direction (aligned or not) with comparable advantages may be achieved.

According to a further embodiment, the terminal section(s) is/are exposed at a sidewall of the inductor inlay, in particular flush with said sidewall.

According to a further embodiment, the terminal section(s) is/are exposed at both (opposed) main surface of the inductor inlay.

These embodiments may enable an especially efficient and robust electrical connection, e.g. when the inductor element is embedded or mounted to a component carrier layer stack. The described architecture may be achieved with subtractive or additive (in particular (m)SAP) processes, e.g. as described in this document.

According to a further embodiment, the component carrier (inlay) is manufactured using an additive SAP (or mSAP) process. It may result from this process that the shape of the metal (copper) traces (inductor element) inside the magnetic material is cuboid-like and/or trapezoidal, in particular the angle between the horizontal expansion (x, y direction) and the vertical direction (z) of the metal trace(s) is between 75° and 105°, more preferable between 80° and 100°, more preferable between 85° and 95°. This may provide the advantage of an improved signal performance.

According to a further embodiment, the at least two terminal sections have a larger vertical and/or larger horizontal extension than a central section of the inductor element that is located between said terminal sections. This measure may enable an efficient and robust electrical contact to the embedded inductor element. For example, vias or other electric connectors of a component carrier may be easily and reliably connected to the inductor element by a large terminal connection (like a pad). Further, the terminals may respectively comprise a pad, for example on a main surface of the inlay. In an embodiment, the at least two terminals are exposed on the same main surface to the inductor inlay. In a preferred embodiment, a terminal connection is configured as a via (see below).

According to a further embodiment, the inductor inlay further comprises at least one electrically conductive via, being a blind via or a through-hole via, that extends at least partially through the magnetic layer stack, and that connects the inductor element to an exterior surface of the inductor inlay. Said electrically conductive via may be configured as one of the above described terminal sections.

According to a further embodiment, the at least one electrically conductive via is filled at least partially with electrically conductive material. According to a further embodiment, the at least one electrically conductive via is a hollow lining which is filled at least partially with an electrically insulating material, in particular a resin. In this manner, a reliable electric connection can be provided.

In the context of the present document, the term "via" (vertical interconnection access) may refer to an electrical connection between layers in a physical electronic circuit that goes through the plane of one or more adjacent layers. The term via may include through-hole vias, buried vias, and blind vias. While vias may be used to connect only a few layers (in a stack) with each other, a "plated through hole" may be used to connect all layers of a stack. Microvias are used as interconnects between layers in high density interconnect (HDI) substrates and printed circuit boards (PCBs) to accommodate the high I/O density of advanced packages. In the present document, an electrically conductive through connection may be called a via.

According to a further embodiment, the at least one electrically conductive via is filled at least partially (in particular fully) with electrically conductive material. Thereby, the holes of the inlay can be manufactured (e.g. mechanically drilled) using established and standardized PCB methodology such as via formation. A metal-filled via may be considered more robust and stable than an unfilled via.

According to a further embodiment, the at least one (electrically conductive) via is a hollow lining which is filled at least partially with an electrically insulating material, in particular a resin. This may provide the advantage that the through connection is more robust/stable and/or can be designed in a flexible manner regarding different functionalities. For example, the hole may be drilled through the magnetic matrix and then, the sidewalls of the hole are plated with conductive material (e.g. copper). Afterwards, the hollow lining (cavity) can be filled partially or completely with an insulating material, for example resin such as insulator ink.

According to a further embodiment, at least one of the vias is a circular (cylindrical) or frustoconical hole.

According to a further embodiment, the method further comprises
i) forming a dielectric layer (in particular a photo-imageable layer) (e.g. on a temporary carrier),
ii) patterning the dielectric layer to form a patterned dielectric layer (with cavities), and
iii) arranging, in particular plating, a metal in the patterned dielectric layer (in the cavities), thereby forming the inductor element.

The dielectric layer may be placed on a substrate, e.g. a temporary carrier (see below) and may be structured (e.g. by photo-lithography) to yield a coil-like (cavity) shape. Then, a metal such as copper may fill the patterned part to form the inductor element in material of the dielectric layer. In case that a temporary carrier is used, the dielectric layer may be arranged directly on a metal surface of said temporary carrier. Thus, when the dielectric layer is structured, the temporary carrier surface below is preferably exposed. When the temporary carrier surface comprises a metal such as copper, the cavities of the patterned dielectric layer may be filled by plating, wherein the metal of the exposed temporary carrier surface serves as a seed layer.

According to a further embodiment, vertical sidewalls of the inductor element metal trace are (essentially) straight. This feature may reflect a specific manufacture (of the inductor element), e.g. an additive process (in particular SAP, more in particular mSAP) (see above).

According to a further embodiment, the inductor element is manufactured at least partially with a subtractive process, which e.g. applies a mask and uses etching techniques (chemical /physical).

According to a further embodiment, the method further comprises:
i) forming a further dielectric layer on the patterned dielectric layer, thereby embedding the inductor element (in dielectric material),
ii) patterning the further dielectric layer to expose a part of the embedded inductor element, and
iii) arranging, in particular plating, a further metal on the exposed part of the inductor element surface, thereby forming terminal sections for the inductor element.

In principle, the same process as describes above is repeated here. In this manner, different height (vertical) structures of the inductor element may be efficiently provided. For example, terminal connections that vertically extend from the planar inductor element can thereby be formed.

In the context of the present document, the term "dielectric layer (structure)" may refer to any dielectric material that can be formed (in particular laminated) as a layer structure (e.g. a photo-film). Further, the dielectric layer can be patterned, e.g. a plurality of cavities (in form of a coil-like shape) may be formed in the dielectric layer structure, in particular by using one of photo-imaging, etching, pre-cutting.

In an example, the dielectric layer comprises a PID material. In another example, the dielectric layer comprises a resist layer, in particular a photo-resist layer.

In the context of the present document, the term "photo-imageable dielectric layer structure" may refer to any dielectric (layer) structure that is configured to be treated (shows an effect) using photo-imaging. In particular, the term refers to a PID dielectric layer structure into which a cavity can be formed using (only) photo-imaging techniques. Preferably, a PID layer structure comprises a non-fiber enforced resin, e.g. polyimide. A base material for a PID application may include: i) thermosetting material, e.g. epoxy, BCB, phenol, ii) thermoplastic material: PI, PBO. The PID material may further comprise a photo initiator (photo sensitive agent) that may be cured by photo UV light. The PID material may be laminated on a substrate (e.g. the stack) and may then be exposed to a lithographic source via a pattern mask, wherein the pattern mask defines the to be manufactured cavities. A portion of the PID material may be developed and one of an exposed portion and an unexposed portion (positive or negative photolithography may be used) may be removed to obtain a plurality of cavities. Examples of photolithography processes may include X-ray lithography, UV lithography, stereo lithography, e-beam lithography and laser lithography.

According to a further embodiment, the method further comprises: arranging, in particular laminating, a first magnetic layer onto the inductor element surface (in particular removing the dielectric layer(s) before arranging the first magnetic layer).

According to a further embodiment, the method further comprises: arranging, in particular laminating, a second magnetic layer onto a back-side surface of the inductor element, wherein the back-side surface is opposed to the inductor element surface.

This may provide the advantage that the above described (vertically extended) inductor element can be embedded in magnetic material efficiently. In another embodiment, the inductor element may be produced by additive manufacturing, e.g. 3D printing or laser sintering.

According to a further embodiment, the method further comprises:
i) providing a temporary carrier with a surface layer, in particular metal layer,
ii) arranging the dielectric layer on the surface layer (in particular on the surface of the metal layer).

In particular, patterning the dielectric layer further comprises:
iii) exposing the surface layer below the patterned dielectric layer.

As described above, a temporary carrier (in particular with a metal foil covered main surface) can be used as a substrate to form the inductor element. An exposed metal surface may serve as a seed layer for filling the cavity by plating.

According to a further embodiment, the method further comprises: removing the temporary carrier with the surface layer before arranging the second magnetic layer on the back-side surface of the inductor element.

According to a further embodiment, the method further comprises: removing the temporary carrier with the surface layer after arranging the first magnetic layer on the inductor element surface.

According to a further embodiment, the removing comprises or consists of at least one of the group which consists of grinding, releasing by UV treatment or laser treatment, etching, in particular dry etching.

According to a further embodiment, arranging the dielectric layer and/or the further dielectric layer comprises lamination using at least one of heat and pressure.

According to a further embodiment, the dielectric layer is a photo-imageable dielectric, PID, and wherein patterning comprises exposing a part of the dielectric layer and/or the further dielectric layer to photolithography.

According to a further embodiment, pattering comprises removing a part of the dielectric layer and/or the further dielectric layer by etching or pre-cutting.

According to a further embodiment, placing the first magnetic layer and/or the second magnetic layer further comprises screen printing.

According to a further embodiment, the component carrier is configured as an integrated circuit (IC) substrate, wherein an IC substrate resembles an IC-sized high density PCB.

According to a further embodiment, wherein at least one electrically conductive structure of the stack is electrically connected to the inductor element of the inductor inlay, in particular via the terminal sections.

According to a further embodiment, at least one electrically conductive structure of the component carrier stack is electrically connected to the electrically conductive structure of the inductor inlay. This may provide the advantage that the electrically conductive structures of the inlay can be directly coupled/connected with the electrically conductive structures of the component carrier. While conventionally, through holes of the component carrier had to be equipped in a cumbersome manner with magnetic material, the described inlay enables an easy, yet robust, integration and electrical connection. For example, electrically conductive vias of the component carrier may be electrically connected to horizontally oriented electrically conductive pads (traces) and/or the terminal connection (vias) of the inductor inlay.

According to a further embodiment, the at least one electrically conductive layer structure (inductor element) is electrically coupled with at least one electrically conductive via to the stack. Thereby, the electrically conductive structure may be embedded in a stable and robust manner in the magnetic matrix, while an efficient electrical connection to (electrically conductive layer structures such as vias) of the stack is enabled.

According to a further embodiment, the inductor inlay is embedded in the stack, so that the directions of main extension (x, y) of the inductor inlay are essentially parallel (see Figure 2) or essentially perpendicular (see Figure 4) to the directions of main extension (x, y) of the component carrier.

In case that the inductor inlay and the component carrier are plate-shaped (in particular planar), they may be oriented parallel with respect to each other. This may provide the advantage of a high inductance value (see above) that can be provided in an easy manner. It should be noted that the magnetic field of a horizontally (planar) oriented inductor inlay may be perpendicular to a magnetic field of a conventional coaxial winding (with respect to the component carrier).

According to a further embodiment, the inductor inlay is assembled to the stack, so that a direction of main extension (x) of the inductor inlay is (essentially) perpendicular to a direction a main extension (x) of the component carrier (while a direction of non-main extension (z) of the inductor inlay may be oriented in parallel with the component carrier direction of main extension (x). In other words, the inductor inlay is embedded or surface mounted vertically.

This embodiment may provide the advantage that the inductor inlay (or a plurality of inductor inlays) may be arranged in a robust manner within (e.g. a core structure) of the stack. The inlay(s) may be arranged in parallel with electrically conductive (through) vias of the component carrier (stack) and an electrical contact may be established by blind vias of the component carrier. Such vertically oriented inductor inlays may be further electrically connected with each other (e.g. to provide a further coil). In a specific example, it may be taken into account that the magnetic flux from the first inlay does not cancel the magnetic flux of the second inlay due to opposite coil direction (current flow).

According to a further embodiment, the inductor inlay is embedded in the stack. According to a further embodiment, the inductor inlay is surface mounted on the stack.

The inductor inlay may be a separate component compared with the component carrier and is manufactured in a separate process. Thus, the inlay may be considered as a flexibly usable element (yet a finished product) that can be integrated in the component carrier (not yet a finished product) manufacturing process. Depending on the desired functionality, the inlay can be efficiently embedded in a cavity of the component carrier (e.g. encapsulated in resin such as prepreg) or be surface mounted on a main surface of the component carrier (e.g. using an adhesive). While embedding may be considered as a robust protection of the inlay, surface mounting may facilitate electric connections to the inlay.

In a further embodiment, the inductor inlay may be configured for shielding electromagnetic radiation from propagating within the component carrier or within the stack (for instance from a first portion of the stack to a second portion of the stack). The inductor inlay may however also be configured for shielding electromagnetic radiation from propagating between component carrier and an environment. Such a shielding may include a prevention of electromagnetic radiation from propagating from an exterior of the component carrier to an interior of the component carrier, from an interior of the component carrier to an exterior of the component carrier, and/or between different portions of the component carrier. In particular, such a shielding may be accomplished in a lateral direction of the stack (i.e. horizontally) and/or in a stacking direction of the stack (i.e. vertically). In such an embodiment, the inductor inlay may function for shielding electromagnetic radiation to thereby suppress undesired effects of electromagnetic interference (EMI), in particular in the radiofrequency (RF) regime.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact. The term "layer structure" may particularly denote a continuous layer, a patterned layer or a plurality of nonconsecutive islands within a common plane.

In an embodiment, the component carrier is shaped as a plate. This contributes to the compact design, wherein the component carrier nevertheless provides a large basis for mounting components thereon. Furthermore, in particular a bare die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component may be embedded in the component carrier and/or may be surface mounted on the component carrier. Such a component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable.

A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

### Brief Description of the Drawings

The aspects defined above and further aspects of the invention are apparent from the examples of embodiment to be described hereinafter and are explained with reference to these examples of embodiment.
Figure 1 shows a side view of an inductor inlay according to an exemplary embodiment of the invention.
Figure 2 shows a side view of a component carrier with the inductor inlay according to an exemplary embodiment of the invention.
Figure 3 shows a top view of the inductor inlay according to an exemplary embodiment of the invention.
Figure 4 shows a side view of a component carrier with the inductor inlay according to another exemplary embodiment of the invention.
Figures 5a to 5k illustrate a manufacturing method to provide the inductor inlay according to an exemplary embodiment of the invention.
Figures 6a and 6c show a further manufacturing method to provide the inductor inlay according to another exemplary embodiment of the invention.
Figures 7a to 7e show different design of the inductor element.
Figure 8 shows a simulation of the inductance value with respect to the designs of Figure 7.
Figures 9a and 9b show different thicknesses of the inductor element in relation to the magnetic layer stack.
Figure 10 shows a simulation of the inductance value with respect to the designs of Figure 9.
Figures 11a to 11c show different line/space ratios of the inductor element and the magnetic matrix.
Figure 12 shows a simulation of the inductance value with respect to the designs of Figure 11.
Figures 13a to 13c show an inductor inlay according to an exemplary embodiment of the invention, respectively.
Figure 14 shows a side view of an inductor inlay according to a further exemplary embodiment of the invention.
Figure 15 shows a side view of an inductor inlay according to a further exemplary embodiment of the invention.

### Detailed Description of the Drawings

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment, the invention uses inductor inlays which are embedded in the inner layers of the substrate core of a component carrier, e.g. by ECP^{®} technology. On the one hand side, these inlays allow the usage of materials with higher magnetic permeability, on the other hand the design can be optimized and tailored to a dedicated application. As a consequence, the inlays can achieve much higher inductance which is required for the next generations of microprocessors and substrates. Further, this invention describes processes to manufacture inductor inlays from magnetic sheets with embedded copper structures.

**Figure 1** shows a side view of an inductor inlay 150 according to an exemplary embodiment of the invention. The inductor inlay 150 comprises a magnetic layer stack 160 with a plurality of interconnected magnetic layers. Between a first magnetic layer 161 and a second magnetic layer 162, there is arranged an electrically conductive structure 120 embedded in the magnetic layer stack 160. The electrically conductive structure 120 is configured as an inductor element 120 that comprises a coil-like shape. In between the coil-like shape, there is arranged magnetic material (which continuously fills a space between conductor track and magnetic matrix and) which can be considered as a third magnetic layer 163 of the magnetic stack 160.

The inductor inlay 150 is shaped as a plate (i.e. planar) and can comprises an ultra-thin thickness (e.g. 100 µm thick and 1000 µm in length). The electrically conductive structure 120 is arranged in the center of the inductor inlay 150, both in the vertical direction (along the z-axis) and in the horizontal direction (along the x- and γ-axes). The electrically conductive structure 120 comprises windings (see also Figure 3). The inductor inlay 150 is configured so that, depending on the thickness and the shape of the electrically conductive structure 120, a specific inductance value is provided for the inductor inlay 150. This inductance value can be adjusted based on e.g. the thickness and the shape of the electrically conductive structure 120. Further, the magnetic permeability of the magnetic matrix 155 can be chosen accordingly.

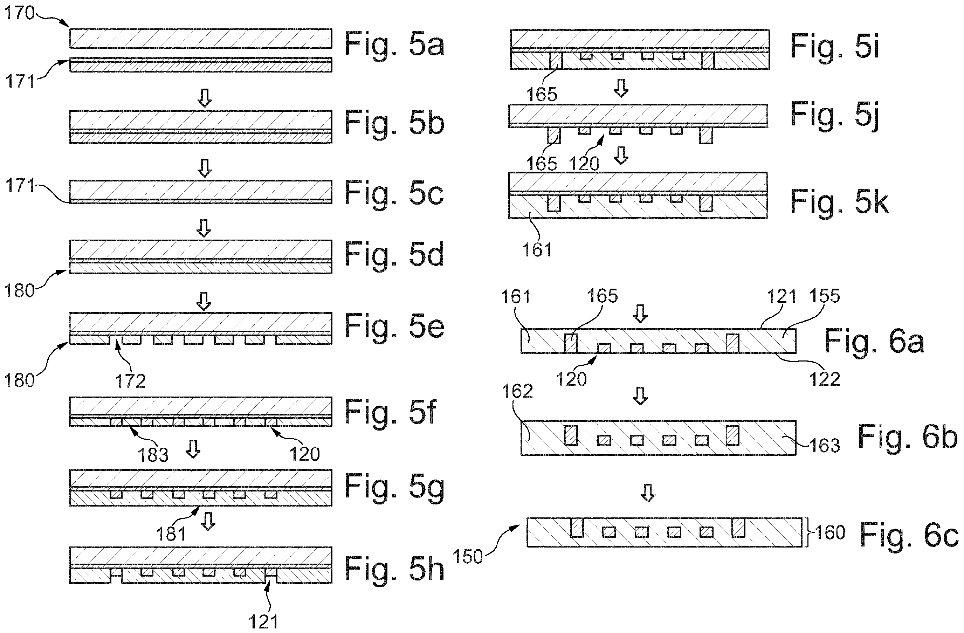

The inductor element 120 comprises at least two terminal sections 165 exposed with respect to the magnetic layers 161, 162 and/or the magnetic layer stack 160. The terminal sections 165 have a larger vertical (along the z-direction) extension than a central section 166 of the inductor element 120 that is located between said terminal sections 165. In this example, the terminal sections 165 are configured as electrically conductive blind vias, that extend at least partially through the magnetic layer stack 160 (here through the second magnetic layer 162) and connect the inductor element 120 to an exterior (main) surface of the inductor inlay 150. Both terminal sections 165 are orientated to the same upper main surface of the inductor inlay 150, where they can be electrically connected to pads and/or vias and/or conductor tracks. This design reflects a manufacturing process (see Figure 5 below), wherein a two-step build-up (using e.g. photo-lithography) on a temporary carrier is applied.

**Figure 2** shows a side view of a component carrier 100 with the inductor inlay 150 according to an exemplary embodiment of the invention.
The component carrier 100 comprises a layer stack 110 with electrically conductive layer structures 104 and electrically insulating layer structures 102. The center of the component carrier 100 constitutes an insulating core layer structure 103 (e.g. fully cured resin such as FR4). Electrically conductive through connections in the form of vias extend through the core structure 103 to thereby electrically connect a first (top) main surface with an opposite second (bottom) main surface of the component carrier 100.

The above described inductor inlay 150 is embedded within the insulating core layer structure 103 and encapsulated with electrically insulating layer stack material 102. In the example shown, the inductor inlay 150 is embedded so that main surfaces of the insulating core structure 103 and the inductor inlay 150 are flush (both comprise a respective thickness of 100 µm).

The two terminal sections 165 are electrically connected through pads to electrically conductive structures (blind vias) 104 of the component carrier (100). Thereby, the inductor inlay 150 is fully integrated and connected to the component carrier 100.

**Figure 3a** shows a top view of the inductor inlay 150 according to an exemplary embodiment of the invention. It can be seen that the inductor element 120 is formed by an electrically conductive structure 120 (e.g. copper) winding that is formed in the magnetic material 155 in a rectangular coil-like manner. In the example shown, the element 120 comprises seven windings. A starting point and an end point of the windings 120 are respectively electrically connected to a terminal (in particular by the via 165). When an electric current is provided to the inductive element 120, an inductance is provided which is in turn enhanced by the magnetic permeability of the magnetic matrix 155. Since the stack 160 comprises a planar shape, the electrically conductive structure 120 is oriented horizontally with respect to the component carrier 100. By providing the magnetic matrix 155, a large amount of magnetic material can be applied and, as a consequence, a high inductance value can be obtained.

**Figure 3b** shows a side view of the inductor inlay 150 of Figure 3b, wherein the magnetic flux in indicated by arrows.

**Figure 4** shows a component carrier 100 according to another exemplary embodiment of the invention. While in Figure 2 the inductor inlay 150 is arranged horizontally in the component carrier 100 (i.e. the directions of main extension (along the indicated x and y axes) of the inductor inlay 150 are oriented in parallel with the directions of main extension of the component carrier 100), there are a plurality of inductor inlays 150 oriented vertically in the component carrier 100 (i.e. the direction of main extension (along the indicated x axis) of the inductor inlay 150 is oriented perpendicular with the direction of main extension (x) of the component carrier 100). The terminal sections 165 of the inductor inlay 150 are electrically connected to respective blind vias 104 of the component carrier 100 along the z-direction. In the example shown, the inductor inlays 150 are embedded in the insulating core layer structure 103 of the component carrier 100. The component carrier 100 further comprises through-hole vias that are oriented in parallel with the embedded inductor inlays 150. The inductor inlays 150 can comprise a respective length of 1000 µm (same as the insulating core structure 103), so that exposed surfaces of the inductor inlay 150 may be flush with the upper/lower main surface of the insulating core layer structure 103. In another example, the inductor inlays can be embedded in one or more electrically insulating layer structures that are not necessarily core structures.

**Figures 5a to 5k** illustrate a manufacturing method to provide the inductor inlay 150 according to an exemplary embodiment of the invention.

Figures 5a and 5b: a temporary carrier 170 is provided, wherein the temporary carrier 170 comprises a resin, preferably a grindable resin such as FR1. A copper foil 171 is provided on a copper carrier and laminated to one of the main surfaces of the temporary carrier 170.

Figure 5c: the copper carrier is removed, thereby leaving the copper foil 171 attached to said temporary carrier 170 main surface.

Figure 5d: a dielectric layer 180 is arranged on the copper foil 171. The dielectric layer 180 comprises in this example a PID (photo-imageable dielectric) material.

Figure 5e: the dielectric layer 180 is patterned, whereby dielectric material is removed to partially expose the copper foil 171 in an exposed structured part 172. In this example, photo-lithography is used to structure (expose and develop) the PID material 180. The exposed structured part 172 comprises a coil-like shape.

Figure 5f: the exposed structured part 172 of the dielectric layer 180, where the surface of the copper foil 171 is exposed, is filled (for example plated) with copper, thereby forming the inductor element 120, wherein the electrically conductive structure 120 is configured as the inductor element 120, that comprises a coil-like shape, in a structured and plated dielectric layer 183.

Figure 5g: a further dielectric layer 181 (which comprises in this example also a PID (photo-imageable dielectric) material) is arranged on the dielectric layer 180 and the inductor element 120, so that the inductor element 120 is fully encapsulated by dielectric material 180, 181.

Figure 5h: the further dielectric layer 181 is patterned, whereby dielectric material is removed to only partially expose the embedded inductor element 120. In this example, photo-lithography is used to structure (expose and develop) the further PID material 181. The structured part comprises a shape of a blind via and exposes a surface 121 of the inductor element 120.

Figure 5i: the structured part of the further dielectric layer 181, where the surface of the embedded inductor element 120 is exposed, is filled (for example plated) with copper, thereby forming terminal sections 165 for the inductor element 120.

Figure 5j: the dielectric layer 180 and the further dielectric layer 181 are fully removed (stripped), thereby exposing the inductor element 120 with its vertically enlarged terminal sections 165. The manufacturing process of forming the inductor element 120 with the terminals 165 in a two-step process on a temporary carrier is reflected in the final product in that both terminals are oriented to the same inductor inlay main surface.

Figure 5k: a first magnetic layer 161 is arranged (laminated) onto the inductor element surface 121. The inductor element 120 gets fully encapsulated by magnetic material 155, so that a third magnetic layer 163 is formed in between the windings of the coil. The magnetic layer 161, 163 can be provided as a magnetic material sheet (instead of a paste).

**Figures 6a and 6c** show a further manufacturing method (based on the method describes for Figure 5) to provide the inductor inlay 150 according to another exemplary embodiment of the invention.

Figure 6a: the temporary carrier 170, which includes the copper foil 171, of the product of Figure 5k is removed. Removing can for example be done by grinding the grindable material 170 and also the copper foil 171. The inductor element 150 is now partially exposed at its back-side surface 122 (which is opposed to the surface 121).

Figure 6b: a second magnetic layer 162 is arranged (laminated) onto the back-side surface 122 of the inductor element 120, wherein the back-side surface 122 is opposed to the inductor element surface 121. Again, the inductor element 120 is fully encapsulated, but not in the dielectric layers 180, 181, but in magnetic matrix material 155. By interconnecting the first magnetic layer 161 and the second magnetic layer 162 (and the third magnetic layer 163), the magnetic layers 161, 162, 163 are stacked to provide the magnetic layer stack 160.

Figure 6c: the inductor inlay 150 with the magnetic layer stack 160, as described for Figure 1, is now obtained. The upper main surface can be processed, in particular grinded, to expose the conductive terminals 165 of the embedded inductor element 120.
**Figures 7a to 7e** show different designs of the inductor element 120.
Figure 7a: square, rectangular coil-shape.
Figure 7b: circular coil-shape.
Figure 7c: hexagonal (rectangular) coil-shape.
Figure 7d: octagonal (rectangular) coil-shape.
Figure 7e: meander-like coil-shape.

**Figure 8** shows a simulation of the inductance value with respect to the designs described for Figure 7. On the x-axis, there is given the permeability (µ), while the inductance (in nH) is provided along the γ-axis. It can be seen that the squared coil-shape shows an improved inductance compared to the other designs. For example, the square uses more efficiently the area (frequency resistance) than the circle. The square has further a longer conductor track than the hexagon.

**Figures 9a and 9b** show different thicknesses of the inductor element 120 in relation to the magnetic layer stack 160.

Figure 9a: here, the thickness (height along z) of the inductor element 120 is high, for example 50 µm, while the first and second magnetic layers 161, 162 have a thickness of 25 µm respectively.

Figure 9b: the thickness (height along z) of the inductor element 120 is low, for example 18 µm, while the first and second magnetic layers 161, 162 have a thickness of 41 µm respectively.

**Figure 10** shows a simulation of the inductance value (using a square shape) with respect to the designs of Figure 9 (and a further design with a 35 µm thick inductor element 120). It can be seen that a higher inductance value can be achieved with thicker magnetic layers 161, 162 (Figure 9b) in comparison to a thicker inductor element 120. Thus, a high magnetic layer material/inductor element material ratio can be preferable.

**Figures 11a to 11c** show different line (conductor track)/space (magnetic material) ratios (along the horizontal direction) of the inductor element 120 (using a square, 18 µm height) and the magnetic layer stack 160.

Figure 11a: in this example, the line/space ratio is 50/50 µm (low number of windings, thick conductor track).

Figure 11b: in this example the line/space ratio is 35/45 µm.

Figure 11c: in this example the line/space ratio is 20/20 µm (high number of windings, thin inductor trace).

**Figure 12** shows a simulation of the inductance value with respect to the inductor element (using square, 18 µm thickness) designs of Figure 11. It can be seen that, the smaller the lines and spaces are (20/20 µm is here preferable), the larger is the inductance value. It should be kept in mind, however, that high inductance values are not strictly the perfect choice, since the Rdc values have to be considered as well and should not be too high. In this context, the term Rdc value may describe how much resistance will be present at direct current, whereby less resistance may be desired in the present case.

**Figure 13a** shows an embodiment of the inlay 150, where the magnetic stack 160 comprises two inductor elements 120a, 120b stacked one above the other in the z-direction. The magnetic stack 160 comprises in this example five magnetic layers, two for embedding the inductor elements 120a, 120b respectively, and three above, below, and in between, respectively. In this example, the inductor element 120a and the further inductor element 120b are perfectly aligned in the z-direction.

**Figure 13b** shows a further embodiment of the inlay 150, where the magnetic stack 160 comprises two inductor elements 120a, 120b stacked one above the other in the z-direction. However, in this example, the inductor element 120a and the further inductor element 120b are not perfectly aligned, but shifted with respect to each other.

**Figure 13c** shows an embodiment of an inductor element arrangement that comprises two of the described inductor inlays 150a, 150b stacked on top of each other. By this measure, a very similar architecture as described for Figures 13a and 13b can be obtained. While in this embodiment, the respective inductor elements 120a, 120c are aligned in the vertical direction, there can be no alignment in another embodiment.

**Figure 14** shows the inductor inlay 150 according to a further exemplary embodiment. In this example, the terminal section 165 is arranged at the edge portion of the inductor inlay 150, i.e. is flush with a sidewall of the inductor inlay 150. Further, the terminal section 165 is flush with one main surface (top or bottom) of the inductor inlay 150. This specific embodiment can be manufactured using a subtractive or additive (in particular (m)SAP) process, for example using the method described in Figure 5. Depending on the manufacture process, the inductor element 120 can be formed with two process steps, so that there can be a demarcation line in the inductor element 120 along the horizontal direction.

**Figure 15** shows the inductor inlay 150 according to a further exemplary embodiment. This example is very similar to the one shown in Figure 14, with the difference that the terminal section 165 is additionally exposed at both (opposed) main surfaces of the inductor inlay 150.

### Reference signs

- 100: Component carrier
- 102: Electrically insulating layer structure
- 103: Core layer structure
- 104: Electrically conductive layer structure, via of component carrier
- 110: Layer stack
- 120: Inductor element, conductive track
- 120a: Inductor element
- 120b: Further inductor element
- 120c: Other inductor element
- 121: Inductor element surface
- 122: Inductor element back-side surface
- 150: Inductor inlay
- 150a: Inductor inlay
- 150b: Further inductor inlay
- 155: Magnetic material (matrix)
- 160: Magnetic layer stack
- 161: First magnetic layer
- 162: Second magnetic layer
- 163: Third magnetic layer, embedding part
- 165: Terminal section
- 166: Central section
- 170: Temporary carrier
- 171: Metal layer
- 172: Exposed part of metal layer
- 180: Dielectric layer
- 181: Further dielectric layer
- 183: Patterned (and plated) dielectric layer

## Claims

1. An inductor inlay (150), comprising:
a magnetic layer stack (160), comprising a plurality of interconnected magnetic layers (161, 162); and
an electrically conductive structure (120) embedded in the magnetic layer stack (160), wherein the electrically conductive structure (120) is configured as an inductor element (120) that comprises a coil-like shape.

2. The inductor inlay (150) according to claim 1,
wherein the magnetic layer stack (110) comprises exactly two magnetic layers (161, 162) or exactly three magnetic layers.

3. The inductor inlay (150) according to claim 1 or 2,
wherein the inductor element (120) is embedded horizontally in the magnetic layer stack (160), or
wherein the inductor element (120) is embedded vertically in the magnetic layer stack (160).

4. The inductor inlay (150) according to any one of the preceding claims, wherein at least one of the magnetic layers (161, 162) is partially or entirely dielectric;
and/or
wherein at least one of the magnetic layers (161, 162) comprises a magnetic matrix (155);
and/or
wherein the magnetic matrix (155) comprises a dielectric material, in which magnetic particles are embedded, in particular wherein the metallic particles comprise at least one of the group consisting of ferrite, a 3d material, and a 4f material;
and/or
wherein the magnetic matrix (155) continuously fills a volume around the inductor element (120);
and/or
wherein the magnetic matrix (155) comprises a rigid solid and/or a paste;
and/or
wherein the magnetic matrix (155) is electrically insulating;
and/or
wherein the relative magnetic permeability µᵣ of the magnetic matrix (155) is in a range from 1.1 to 500, in particular 2 to 150, more in particular 4 to 80;
and/or
wherein the magnetic matrix (155) comprises at least one material of the group consisting of a ferromagnetic material, a ferrimagnetic material, a permanent magnetic material, a soft magnetic material, a ferrite, a metal oxide, a dielectric matrix, in particular a prepreg, with magnetic particles therein, and an alloy, in particular an iron alloy or alloyed silicon.

5. The inductor inlay (150) according to any one of the preceding claims, wherein the inductor element (120) is meander-shaped and/or spiral-shaped.

6. The inductor inlay (150) according to any one of the preceding claims, wherein the inductor element (120) comprises at least two terminal sections (165) exposed with respect to the magnetic layers (161, 162), in particular with respect to the magnetic layer stack (160).

7. The inductor inlay (150) according to claim 6,
wherein the at least two terminal sections (165) have a larger vertical and/or larger horizontal extension than a central section (166) of the inductor element (120) that is located between said terminal sections (165).

8. The inductor inlay (150) according to any one of the preceding claims, wherein the inductor inlay (150) further comprises:
at least one electrically conductive via, being a blind via or a through-hole via, that extends at least partially through the magnetic layer stack (160), and that connects the inductor element (120) to an exterior surface of the inductor inlay (150),
wherein the at least one electrically conductive via is filled at least partially with electrically conductive material, or
wherein the at least one electrically conductive via is a hollow lining which is filled at least partially with an electrically insulating material, in particular a resin.

9. A method of manufacturing an inductor inlay (150), wherein the method comprises:
stacking a plurality of magnetic layers (161, 162) to provide a magnetic layer stack (160), thereby:
interconnecting the plurality of magnetic layers (161, 162); and
embedding an electrically conductive structure (120) in the magnetic layer stack (160), wherein the electrically conductive structure (120) is configured as an inductor element (120) that comprises a coil-like shape.

10. The method according to claim 9, further comprising:
forming a dielectric layer (180), in particular a photo-imageable layer;
patterning the dielectric layer (180) to form a patterned dielectric layer (183); and
arranging, in particular plating, a metal in the patterned dielectric layer (183), thereby forming the inductor element (120).

11. The method according to claim 10, further comprising:
forming a further dielectric layer (181) on the patterned dielectric layer (183), thereby embedding the inductor element (120);
patterning the further dielectric layer (181) to expose a part of the embedded inductor element (120); and
arranging, in particular plating, a further metal on the exposed part of the inductor element surface (121), thereby forming terminal sections (165) for the inductor element (120).

12. The method according to claim 10 or 11, further comprising:
arranging, in particular laminating, a first magnetic layer (161) onto the inductor element surface (121), in particular removing the dielectric layer (170) before arranging the first magnetic layer (161),
and/or
arranging, in particular laminating, a second magnetic layer (162) onto a back-side surface (122) of the inductor element (120), wherein the back-side surface (122) is opposed to the inductor element surface (121).

13. The method according to any one of claims 9 to 12,
further comprising:
providing a temporary carrier (170) with a surface layer, in particular metal layer (171),
arranging the dielectric layer (180) on the surface layer (171),
and wherein patterning the dielectric layer (180) comprises:
exposing the surface layer (171) below the patterned dielectric layer (183); and/or
further comprising:
removing the temporary carrier (170) with the surface layer (171) before arranging the second magnetic layer (162) on the back-side surface (122) of the inductor element (120);
and/or
removing the temporary carrier (170) with the surface layer (171) after arranging the first magnetic layer (161) on the inductor element surface (121); in particular wherein the removing comprises or consists of at least one of the group which consists of grinding, releasing by UV treatment or laser treatment, etching, in particular dry etching.

14. A component carrier (100), wherein the component carrier (100) comprises:
a stack (110) comprising at least one electrically conductive layer structure (104) and at least one electrically insulating layer structure (102); and
an inductor inlay (150) according to any one of the claims 1 to 8,
wherein the inductor inlay (150) is embedded in the stack (110).

15. The component carrier (100) according to claim 14,
wherein the component carrier (100) is configured as an integrated circuit, IC, substrate, wherein an IC substrate resembles an IC-sized high density PCB; and/or
wherein at least one electrically conductive structure (104) of the stack (110) is electrically connected to the inductor element (120) of the inductor inlay (150), in particular via the terminal sections (165);
and/or
wherein the inductor inlay (150) is embedded in the stack (110), so that the directions of main extension (x, y) of the inductor inlay (150) are essentially parallel or essentially perpendicular to the directions of main extension (x, y) of the component carrier (100).
